# EUROPEAN PATENT SPECIFICATION

(11) **EP 3 023 851 B1**
(45) Date of publication and mention of the grant of the patent: **28.03.2018**
(21) Application number: 15193701.8
(22) Date of filing: 09.11.2015
(51) Int. Cl.: G05B 23/00, G05B 23/02

(54) **SYSTEM AND METHOD FOR DETERMINING THE CURRENT AND FUTURE STATE OF HEALTH OF A POWER TRANSFORMER**
SYSTEM UND VERFAHREN ZUR BESTIMMUNG DES GEGENWÄRTIGEN UND ZUKÜNFTIGEN GESUNDHEITSZUSTANDES EINES LEISTUNGSTRANSFORMATORS
SYSTÈME ET PROCÉDÉ PERMETTANT DE DÉTERMINER L'ÉTAT DE SANTÉ ACTUEL ET FUTUR D'UN TRANSFORMATEUR DE PUISSANCE

(30) Priority: 18.11.2014 US 201414546499
(43) Date of publication of application: 25.05.2016
(73) Proprietor: General Electric Company, Schenectady, NY 12345 (US)
(72) Inventor: ROJAS, Hernan A., Atlanta, GA 30339 (US); COSTA, Sergio, Pointe-Claire, Ontario H9R 4Z1 (CA); COSOREANU, Claudia, Markham, Ontario L6E 1A5 (CA); BEATTIE, Stephen, Kidsgrove, Staffordshire 5T7 1TW (GB); PARWAL, Nawal Kishor, Atlanta, GA 30339 (US)
(74) Representative: Cleary, Fidelma

(56) References cited:
- WO-A1-2012/142355
- WO-A2-2014/078830
- US-A1- 2002 161 558

## Description

### BACKGROUND

The subject matter disclosed herein relates to electrical power transformers, and, more specifically, to condition monitoring and assessment for electrical power transformers.

Modern electrical power networks may include a number of electrical substations, each including a variety of equipment to facilitate the conversion of electrical power produced by one or more power production facilities (e.g., nuclear power plants, coal gasification power plants, gas turbine based power plants, hydroelectric power plants, etc.). Such electrical substations include, for example, power transformers, referred to hereafter as transformers, that receive electrical power at a first voltage and output electrical power at a second voltage. Modern transformers are relatively complex devices that include a number of components that may fail in a number of different ways over the estimated 40 year average life span of the transformer. As such, transformers may receive regularly scheduled maintenance and inspections to ensure proper operation. However, since maintenance crews may be limited in number, the maintenance and inspection of transformers may be scheduled well in advance (e.g., 6 months or more in advance). Further, since the infrastructure is not completely homogenous, different transformers within the electrical power network may age or wear at different rates. Unfortunately, the existing servicing of transformers does not address these problems in an efficient manner.

US 2002/0161558 describes a transformer management system using sensors to sense physical quantities associated with the operation of a transformer. Processing circuitry uses the sensed physical quantities to calculate values from mathematical models for representing behavior of the transformer. These calculated values are compared to threshold values and an output is generated based on the result of the comparison. WO 2012/142355 describes a dynamic assessment system for monitoring high-voltage electrical components, including a computer system configured to receive data from a plurality of on-line sensors that monitor various operating parameters associated with a plurality of electrical components. The computer system is configured to automatically and continuously correlate the data from the on-line sensors with data from various off-line databases and supervisory networks associated with monitoring the operation of the power distribution network, so as to generate dynamic operating condition assessments, including risk of failure assessments, of each of the monitored electrical components.

### BRIEF DESCRIPTION

Certain embodiments commensurate in scope with the originally claimed invention are summarized below. These embodiments are not intended to limit the scope of the claimed invention, but rather these embodiments are intended only to provide a brief summary of possible forms of the invention. Indeed, the invention may encompass a variety of forms that may be similar to or different from the embodiments set forth below.

The present invention resides in a system, a method and a computer program as defined in the appended claims.

### BRIEF DESCRIPTION OF THE DRAWINGS

These and other features, aspects, and advantages of the present invention will become better understood when the following detailed description is read with reference to the accompanying drawings in which like characters represent like parts throughout the drawings, wherein:
FIG. 1 is a schematic of an embodiment of an electrical power network that includes at least one transformer diagnosis and prognosis device;
FIG. 2 is a schematic illustrating the flow of operational and non-operational data to the transformer diagnosis and prognosis device, in accordance with an embodiment of the present approach;
FIG. 3 is a schematic of an embodiment of the transformer diagnosis and prognosis device illustrating inputs, outputs, and certain internal components of the transformer diagnosis and prognosis device; and
FIG. 4 is a flow diagram illustrating an embodiment of a process by which the transformer diagnosis and prognosis device may determine a diagnosis and prognosis for the transformer based on a combination of operational and non-operational data.

### DETAILED DESCRIPTION

One or more specific embodiments of the present invention will be described below. In an effort to provide a concise description of these embodiments, all features of an actual implementation may not be described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present invention, the articles "a," "an," "the," and "said" are intended to mean that there are one or more of the elements. The terms "comprising," "including," and "having" are intended to be inclusive and mean that there may be additional elements other than the listed elements.

As used herein, "operational data" refers to data that represents the real-time or near real-time status, performance, and loading of power system equipment. Operational data includes any fundamental information used by operators to monitor and control of the electrical network. A non-limiting list of example operation data includes: circuit breaker status (e.g., open or close), line current, bus voltages, transformer loading (e.g., real and reactive power), substation alarms (e.g., high temperature, low pressure, intrusion), per phase voltage and current vectors, transformer loading (overloading), transient voltage and current events, ambient temperature, winding resistance, leakage reactance, core excitation current, core loss and excitation power factor, and/or core ground. Operational data may generally include time-sequenced data items that are representative of real-time or near real-time values or quantities. Operational data may be collected by an online monitoring device (e.g., a field monitoring device, a remote terminal unit (RTU), an intelligent electronic device (IED), a data concentrator, a networked component of the electrical power network, etc.) that monitors the operation of a transformer. As used herein, "non-operational" refers to data items for which the primary user is someone other than the operators of the electrical power network. For example, while operators may be interested in a limited amount of non-operational data, the primary consumers of non-operational data may be, for example, engineering and/or maintenance personnel. A non-limiting list of example non-operational data includes: digital fault recorder records, circuit breaker contact wear indicator, nameplate data (e.g., nominal rating, current rating), winding power factor, bushing power factor, winding turns ratio, winding vector group, date of manufacture, maintenance logs, stress event logs, asset book value, asset residual value, asset age, spare part inventory list and associated costs, failure logs, data logs from any devices inside the same substation, thermal imaging, and a power delivery network model for the electrical power network. In certain embodiments, at least a portion of the non-operational data may be collected by the same devices that collect operational data (e.g., online monitoring device, a field monitoring device, a RTU, an IED, a data concentrator, a networked component of the electrical power network, etc.). For such embodiments, the non-operational data may be in the form of a data file that includes a collection of historical data and trends gathered over a period of time. In certain embodiments, at least a portion of the non-operational data may be in the form of reports (e.g., purchase orders, inventory reports, maintenance reports, and so forth) that are digitized automatically (e.g., using optical character recognition (OCR)) or manually (e.g., using manual data entry) and stored in a database or another suitable data repository to facilitate electronic access. It may be appreciated that certain data, such as data from dissolved gas analysis (DGA) of transformer oil, may be considered as either operational or non-operational data in different embodiments depending on how the data is collected (e.g., via an online device in real-time or near real time or via a manual measurement when the transformer is offline). Other examples of operational data and non-operational data are provided in U.S. Patent No. 8,484,150.

As set forth above, transformers include a number of components that may fail in a number of different ways. If the transformer is monitored, for example, using a remote terminal unit (RTU), an intelligent electronic device (IED), or a similar online monitoring device, then maintenance of the transformer may be performed in response to a particular condition. This is generally referred to as condition-based maintenance. Condition-based maintenance does offer advantages over strictly schedule based maintenance in terms of improving the efficiency of maintenance crews, improving the life expectancy of the power transformers, and limiting power disturbances on the electrical power network. However, in the absence of the present disclosure, condition-based maintenance is typically triggered by complete or partial failure of one or more of the components of the transformer (e.g., red flag events).

However, since modern transformers include a number of interrelated subsystems that may fail in numerous independent or interrelated ways, it is desirable to monitor each subsystem of the transformer and to use monitoring combination of operational and non-operational data to determine a diagnosis and prognosis for the transformer. Accordingly, present embodiments are directed toward a transformer diagnosis and prognosis device, which is a computing device (e.g., a processor-based electronic system) that receives operational and non-operational data that pertains to a transformer and provides this data as input to a number of stored computer software models (hereinafter "models"). These stored models include a physics-based model that correlates combinations of particular operational and non-operational data values with particular physical phenomena associated with a condition of each subsystem of the transformer, and/or the transformer as a whole, according to the physics that govern the operation and failure of each transformer subsystem. Additionally, the stored models include an empirical model that correlates combinations of particular operational and non-operational data values with particular conditions associated with each subsystem of the transformer and/or the transformer as a whole, according to entrained statistical trends and expert knowledge of issues that particular transformers tend to experience. These stored models provide as outputs a transformer diagnosis (e.g., a computer-generated diagnostic report), which may include a health index, a confidence value, and prescriptive action, as well as a transformer prognosis (e.g., a computer-generated prognostic report), which may include a failure probability, an expected lifetime, and an events probability. The transformer diagnosis and prognosis device may also include a graphical user interface (GUI) that displays the transformer diagnosis and prognosis in a simplistic manner (e.g., numeric ranges, color coding, visual representations in the form of gauges or indicator bars) that is informative to users that are not experts in transformer design or operation.

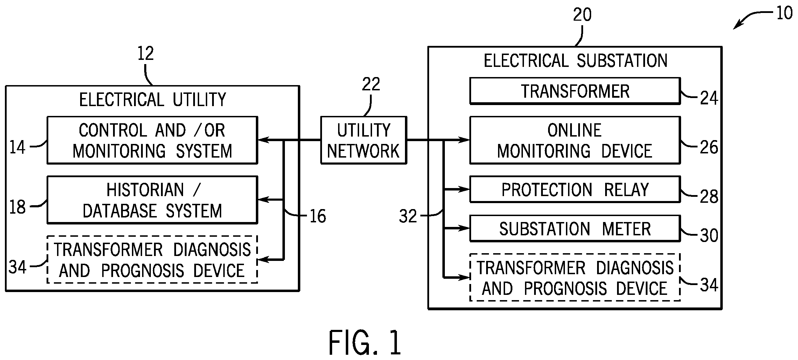

With the foregoing in mind, FIG. 1 illustrates a portion of an electrical power network 10. The electrical power network 10 includes the electrical utility 12, which may include or host a number of systems for controlling and monitoring the electrical power network 10. For example, the electrical utility 12 may include at least one control and/or monitoring system 14, such a supervisory control and data acquisition (SCADA) system, an energy management system (EMS), a distribution management system (DMS), a distributed control system (DCS), or combinations thereof, for controlling and/or monitoring the network 10. The control and/or monitoring system 14 may be communicatively coupled to a local network 16 that may enable the control and/or monitoring system 14 to communicate with other local devices (e.g., historian / database system 18) and with equipment disposed at one or more electrical substations 20 via the utility network 22. The historian / database system 18 may be any suitable data repository (e.g., an asset management system (AMS), a computer maintenance management system (CMMS), an enterprise resource planning (ERP) system, etc.) that stores information regarding the manufacture, the procurement, the installation, the operation, the maintenance and inspection history, the event and/or failure history, and so forth, for the transformers of the electrical power network 10. In certain embodiments, the historian / database system 18 may be populated with mostly or entirely non-operational data received directly from devices coupled to the utility network 22 and/or non-operational data automatically gleaned or manually entered from various reports (e.g., purchase orders, inventory reports, maintenance reports, and so forth).

As illustrated in FIG. 1, an electrical substation 20 may include equipment that facilitates the conversion of electrical power within the electrical power network 10. For example, the electrical substation 20 includes at least one transformer 24 that generally converts electrical power from a first voltage to a second voltage. Such transformers 24 are discussed in greater detail below. The electrical substation 20 also includes at least one online monitoring device 26 (e.g., a relay, a RTU, an IED, a data concentrator, etc.) that collects data from sensors measuring the performance of the equipment of the electrical substation 20. In particular, as illustrated in FIG. 1, the online monitoring devices 26 may be used to monitor the performance of the transformer 24 (e.g., each subsystem of the transformer 24) during operation.

Additionally, other equipment that may be present in the electrical substation 20 may include, for example, a protective relay 28 and/or a substation meter 30. It should be appreciated that, in certain embodiments, other equipment may also be present at the electrical substation 20, such as various switches, tap changers, sensors, monitors, or any other suitable equipment useful in the conversion of electrical power within the electrical power network 10. Further, as illustrated in FIG. 1, the electrical substation 20 may include a local network 32 that enables devices coupled to the local network (e.g., online monitoring device 26, protective relay 28, substation meter 30, and so forth) to communicate with one another, via the local network 32, and to communicate with remote devices or systems, such as the control and/or monitoring system 14, historian/database system 18, and so forth, via the utility network 22.

As illustrated in FIG. 1, the electrical power network 10 may include one or more transformer diagnosis and prognosis devices 34 (e.g., processor-based computing devices). In certain embodiments, as illustrated in FIG. 1, a transformer diagnosis and prognosis device 34 may be disposed at the electrical utility 12 and coupled to the local network 16, which enables the transformer diagnosis and prognosis device 34 to communicate with local systems (e.g., the control and/or monitoring system 14, the historian/database system 18, and so forth) as well as other devices disposed at the electrical substation 20, such as the online monitoring device 26, the protection relay 28, the substation meter 30, and so forth, via the utility network 22. In certain embodiments, as illustrated in FIG. 1, a transformer diagnosis and prognosis device 34 may, additionally or alternatively, be disposed at the electrical substation 20 and coupled to the local network 32, which enables the transformer diagnosis and prognosis device 34 to communicate with other local devices (e.g., online monitoring device 26, protection relay 28, substation meter 30) as well as systems (e.g., the control and/or monitoring system 14, the historian/database system 18) disposed at the electrical utility 12 via the utility network 22. Additionally, in certain embodiments, the transformer diagnosis and prognosis device 34 disposed at the utility 12 or at the substation 20 may be accessible via an Internet or web portal (e.g., coupled to the local networks 16 or 32, or coupled to the utility network 22) to enable remote users to use the transformer diagnosis and prognosis device 34. As such, regardless of whether the transformer diagnosis and prognosis device 34 is disposed at the electrical utility 12, the electrical substation 20, or both, the transformer diagnosis and prognosis device 34 is generally communicatively coupled to any number of devices and systems of the electrical power network 10 to provide the functionality discussed in detail below.

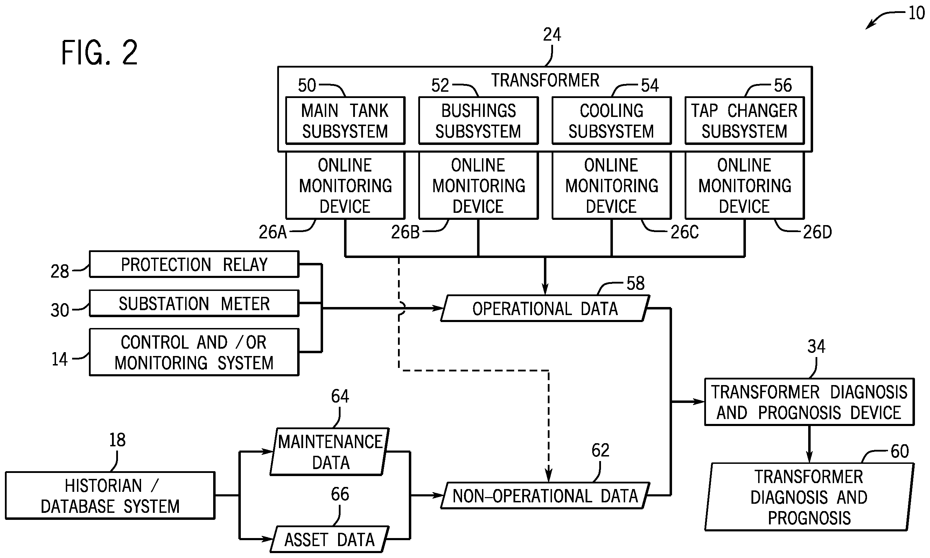

The transformer diagnosis and prognosis device 34 is generally a processor-based computing device that receives information (e.g., analog and digital data) from a number of sources, and this information is then processed in order to determine a diagnosis and prognosis for the transformer 24. FIG. 2 is a schematic illustrating the flow of information to the transformer diagnosis and prognosis device 34 from a number of sources within the electrical power network 10 for an example embodiment. For the embodiment illustrated in FIG. 2, the transformer 24 includes a number of subsystems (e.g., a main tank subsystem 50, a bushings subsystem 52, a cooling subsystem 54, and a tap changer subsystem 56), each monitored by a respective online monitoring device (e.g., online monitoring devices 26A, 26B, 26C, and 26D). In other embodiments, any suitable number of subsystems and/or monitoring devices may be associated with the transformer 24. In other embodiments, the transformer 24 may be divided into or include other subsystems, such as transformer protection subsystems, insulation subsystems, mechanical subsystems, magnetic subsystems, electrical subsystems, and so forth. Further, in certain embodiments, certain subsystems may include multiple online monitoring devices 26 capable of measuring different parameters of the subsystem, while in other embodiments, a single online monitoring device 26 may collect a portion of the operational data 58 from a number of sensing devices respectively associated with the various subsystems 50, 52, 54, and 56 of the transformer 24.

For the embodiment illustrated in FIG. 2, the online monitoring devices 26A-D may respectively perform measurements of the operation of each of the subsystems of the transformer 24 in order to determine at least a portion of the operational data 58 and/or the non-operational data 62 for the transformer 24. For example, in terms of operational data 58, the online monitoring device 26B may include one or more electrical sensors that perform measurements indicative of the electrical performance of the bushings subsystem 52 of the transformer 24 during operation. Online monitoring device 26C may include one or more temperature sensors that perform temperature measurements indicative of the thermal performance of the cooling subsystem 54 of the transformer 24 during operation. Online monitoring device 26D may include one or more electrical sensors that perform electrical measurements indicative of the electrical performance of the tap changer subsystem 56 of the transformer 24 during operation. In certain embodiments, the operational data 58 may also include data received from other devices (e.g., protection relays 28, substation meters 30, or any other networked device) that are disposed in the same electrical substation 20 as the transformer 24, which may also be indicative of the performance of the transformer 24. In certain embodiments, the operational data 58 may, additionally or alternatively, include data that is received from the control and/or monitoring system 14 that is indicative of the performance of the transformer 24.

For the illustrated embodiment, in terms of non-operational data 62, the online monitoring device 26A may be an online dissolved analysis (DGA) device that may be capable of analyzing the oil contained in the main tank subsystem 50. The oil in the main tank generally serves to electrically insulate, protect, and cool the windings and the core of the transformer 24. As such, DGA of this oil can provide important information regarding the operation of the transformer 24, including early indications of potential transformer failures. For example, DGA can measure an increase in the metal content of the oil, which may be indicative of high-temperature metal decomposition of the windings of the transformer 24. Similarly, DGA can also measure an increase in cellulose content of the oil, which may indicate that an insulating material of the transformer 24 is decomposing. Accordingly, in certain embodiments, DGA data (e.g., collected by the online monitoring device 26A) may be part of the non-operational data 62 provided to the transformer diagnosis and prognosis device 34 either directly or indirectly (e.g., after being stored in and retrieved from the historian / database system 18). It may be appreciated that, since the DGA data may be indicative or a real-time or near real-time condition of the transformer 24, in certain embodiments, DGA data may be additionally or alternatively treated as operational data 58.

The transformer diagnosis and prognosis device 34 also receives non-operational or non-operational data 62 for use in determining a diagnosis and prognosis for the transformer 24. For example, as illustrated in FIG. 2, the non-operational data 62 may include maintenance data 64 and asset data 66 provided by the historian/database system 18. This maintenance data 64 may include measurements (e.g., infra-red thermal images, electrical measurements, and so forth) that are collected during maintenance or inspection of the transformer 24, usually while the transformer is offline. Additionally, the maintenance data 64 may include data related to failures or events experienced by the transformer 24 (e.g., type, date, and cause of failure), as well as data related to inspections and repairs performed on the transformer 24 (e.g., service descriptions, parts replaced or repaired, service dates). The asset data 66 may include, for example, data generally related to the manufacture, the installation, the geographic location, the purchase, the value, or the cost of the transformer 24 (e.g., part numbers, serial numbers, date of manufacture, model number, nameplate data). In certain embodiments, the asset data may also include a model of the electrical power network 10, which indicates the relative position and connectivity of the transformer 24 with respect to other components of the electrical power network 10. Accordingly, the transformer diagnosis and prognosis device 34 may receive the operational data 58 and the non-operational data 62 from these various sources for use in determining the diagnosis and prognosis 60 for the transformer 24.

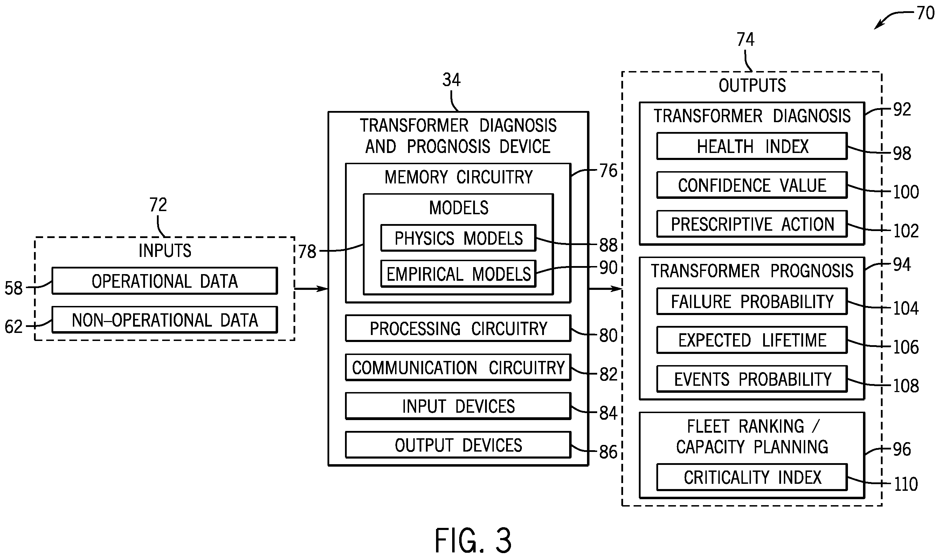

FIG. 3 is a schematic 70 illustrating inputs 72, outputs 74, and certain internal components of the transformer diagnosis and prognosis device 34 for an example embodiment. As illustrated in FIG. 3, the transformer diagnosis and prognosis device 34 includes memory circuitry 76 (e.g., non-volatile memory circuitry or another data storage device) capable of storing instructions as well as a number of models 78, which are discussed in greater detail below. The transformer diagnosis and prognosis device 34 also includes processing circuitry 80 (e.g., a general purpose microprocessor, an application-specific integrated circuit (ASIC), or other suitable processing circuitry) capable of executing instructions to provide the inputs 72 to the stored models 78, and to determine the outputs 74 from the stored models 78. The illustrated transformer diagnosis and prognosis device 34 also includes communication circuitry 82 (e.g., a wired and/or wireless network interface card) to enable the transformer diagnosis and prognosis device 34 to communicate with devices and systems on the local and remote networks, as discussed above. Further, the illustrated transformer diagnosis and prognosis device 34 includes input devices 84 (e.g., a mouse, a keyboard, a touchscreen device) and output devices 86 (e.g., a fixed or mobile display device) to enable a local or remote user to interact with (e.g., provide information to, receive information from) the transformer diagnosis and prognosis device 34.

As mentioned above, the memory circuitry 76 of the transformer diagnosis and prognosis device 34 stores a number of models 78 that receive the inputs 72, namely the operational data 58 and the non-operational data 62 discussed above, and provide the outputs 74 that are discussed in detail below. As mentioned above, these stored models 78 include at least one physics-based model 88 and at least one empirical model 90. For example, in certain embodiments, there may be one or more physics-based models 88 and one or more empirical models 90 for each subsystem (e.g., the main tank subsystem 50, the bushings subsystem 52, the cooling subsystem 54, and the tap changer subsystem 56) of the transformer 24. In certain embodiments, there may be one or more physics-based models 88 and one or more empirical models 90 for the transformer 24 as a whole. Further, in certain embodiments, each of the stored models 78 may be implemented in the form of a collection of equations, graphs, charts, look-up tables, and so forth, which store the correlations between possible combinations of operational data 58 and non-operational data 62 and the current and future state of the transformer 24.

Each physics-based model 88 correlates or associates possible combinations of values of the operational data 58 and the non-operational data 62 with particular physical phenomena that can occur within the transformer 24, based on the physics that govern the operation and failure of the transformer 24. For example, in certain embodiments, the physics-based models 88 may include a physics model storing correlations between potential combinations of values for operational data 58 (e.g., DGA data indicates an increase in metal content of the oil) and particular non-operational data values (e.g., the age of the transformer, infrared camera images) with particular physical phenomena (e.g., metal decomposition at the windings or at an interface) that can occur within the transformer 24 during operation. In certain embodiments, since multiple physical entities (e.g., multiple transformer subsystems) may contribute to the operation and failure of the transformer 24, one or more complex physical models 88 based on these multiple physical entities may be implemented.

Each empirical model 90 correlates possible combinations of values of the operational data 58 and non-operational data 62 with particular conditions of the transformer 24 based on entrained statistical trends and expert knowledge of issues that the transformer 24 tends to have. For example, an empirical model 90 may include correlations that are based on trends that have been identified through statistical analysis of previously collected operational data 58 and non-operational data 62. By specific example, an empirical model 90 may store a statistically identified correlation between certain values of the operational data 58 (e.g., bushings power factor) and non-operational data 62 (e.g., age and model of the transformer) and certain conditions of the transformer 24 (e.g., an impending failure of the bushings subsystem 52 of the transformer 24). Furthermore, in certain embodiments, an empirical model 90 may include correlations that are based on trends identified by experts (e.g., power transformer engineers) based on the expert's experiences in maintaining and diagnosing similar transformers. By specific example, an empirical model 90 may store a correlation, based on expert knowledge or experience, that the bushings subsystem 52 of certain models of transformers tend to fail after approximately 5 years of use.

Accordingly, for the embodiment illustrated in FIG. 3, the processing circuitry 80 of the transformer diagnosis and prognosis device 34 may utilize the inputs 72 and models 78 to determine the outputs 74. For the embodiment illustrated in FIG. 3, the outputs 74 include a transformer diagnosis 92, a transformer prognosis 94, as well as fleet ranking and capacity planning information 96. For the embodiment illustrated in FIG. 3, the transformer diagnosis 92 includes a health index 98, a confidence index 100, as well as prescriptive action 102. The illustrated transformer prognosis 94 includes a failure probability 104, an expected lifetime 106, and an events probability 108 for the transformer 24. It may be appreciated that, in certain embodiments, the output 74 of the transformer diagnosis and prognosis device 34 may be generally designed to be non-technical. In other words, in certain embodiments, a user of the transformer diagnosis and prognosis device 34 need not be an expert in transformer design or maintenance to be able to draw meaningful conclusions about the current and future condition of the transformer 24 from the outputs 74. Additionally, in certain embodiments, the transformer diagnosis and prognosis device 34 may generate the output 74 (e.g., the transformer diagnosis 92 and/or the transformer prognosis 94) for each subsystem (e.g., the main tank subsystem 50, the bushings subsystem 52, the cooling subsystem 54, the tap changer subsystem 56, etc.) of the transformer 24 and/or for the transformer 24 as a whole.

Accordingly, the transformer diagnosis 92 is a representation of the current health of the transformer 24 as well as a collection of recommendations (e.g., inspection, maintenance, and/or control recommendations) for the transformer 24. The health index 98 of the transformer diagnosis 92 may, in certain embodiments, be a numerical value within a particular range (e.g., a number between 1 and 10 or between 1 and 100) that is indicative of the health of the transformer 24. In certain embodiments, the health index 98 may be a particular color within a range of colors (e.g., green for good transformer health, yellow for moderate transformer health, and red for poor transformer health). The confidence value 100 of the transformer diagnosis 92 may, in certain embodiments, be a numerical value within a particular range (e.g., a number between 1 and 10 or between 1 and 100) that is indicative of the degree of confidence that the transformer diagnosis and prognosis device 34 has in relation to the health index 98. That is, the confidence value 100 may be a representation of how well the combination of values of the inputs 72 aligned with the plurality of models 78. Prescriptive action 102 of the transformer diagnosis 92 may, in certain embodiments, be a list or a collection of actions that are recommended to improve or maintain the health of the transformer 24. For example, in certain embodiments, the prescriptive action 102 may include suggestions to inspect the transformer, suggestions to repair or replace of one or more components of the transformer 24, suggestions to operate the transformer 24 differently (e.g., suggestions to overrate or derate the transformer 24), suggestions to cease operations of the transformer 24, suggestions to order spare parts for the transformer 24, and so forth.

The failure probability 104 of the transformer prognosis 94 may, in certain embodiments, be a numerical value within a particular range (e.g., a number between 1 and 10 or between 1 and 100) that is indicative of the probability that the transformer 24 will fail within a particular time frame (e.g., 1 month, 3 months, 6 months, 9 months, 1 year, 2 years, 5 years, etc.) if the transformer 24 continues to operate in the same manner (e.g., if no corrective actions are taken). The expected lifetime 106 of the transformer prognosis 94 may, in certain embodiments, be an amount of time (e.g., in hours, days, months, and/or years) that the transformer 24 is expected to continue operating in the same manner (e.g., without corrective action) before failing. The events probability 108 of the transformer prognosis 94 may, in certain embodiments, be a numerical value within a particular range (e.g., a number between 1 and 10 or between 1 and 100) that is indicative of the probability that the transformer 24 will experience an event that affects performance of the transformer 24 within a particular time frame (e.g., 1 month, 3 months, 6 months, 9 months, 1 year, 2 years, 5 years, etc.). In particular, the events probability 108 may take into account the geographic location of the transformer 24. For example, the events probability 108 of a transformer 24 located in a potential natural disaster zone (e.g., a hurricane zone, a tornado zone, a flood zone, an earthquake zone, a tsunami zone, etc.) may be substantially greater than another transformer that is not located in such a potential natural disaster zone.

The portion of the output 74 pertaining to fleet ranking and capacity planning 96 may, in certain embodiments, be a set of decision support analytics that provide the capability of prioritizing particular transformers within the electrical power network 10. In certain embodiments, the fleet rating and capacity planning information 96 may be based, at least in part, upon the failure probability 104 of the transformer prognosis 94 determined for the transformer 24, as well as other transformers of the electrical power network 10. In certain embodiments, the fleet rating and capacity planning output 96 may be based, at least in part, upon a determined criticality index 110. The criticality index 110 may, in certain embodiments, may be a numerical value within a particular range (e.g., a number between 1 and 100) that represents the relative importance or criticality of a transformer 24 to the operation of the electrical power network 10. For example, the criticality index 110 of a particular transformer 24 may be greater when the transformer 24 operating in an important portion of electrical power network 10, such as a portion of the electrical power network 10 that includes key loads (e.g., hospitals, emergency shelters, governmental facilities, etc.) or a portion of the electrical power network 10 on which several other portions of the network 10 depend. As such, the fleet ranking and capacity planning information 96 enables the prioritization of the maintenance and inspection of more critical transformers 24 of the electrical power network 10. Further, the fleet rating and capacity planning information 96 may also provide information to enable a user to determine with confidence if a particular transformer 24 can be or should be overrated or derated in order to keep key loads energized within the electrical power network 10.

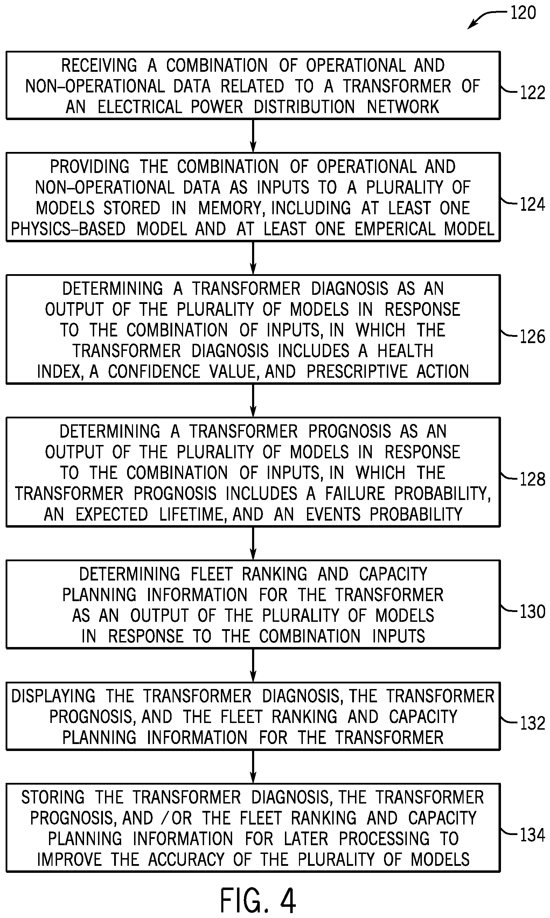

With the foregoing in mind, FIG. 4 is a flow diagram illustrating an embodiment of a process 120 whereby the transformer diagnosis and prognosis device 34 may determine the transformer diagnosis 92, the transformer prognosis 94, and the fleet ranking and capacity planning information 96 for a transformer 24. The process 120 begins with the processing circuitry 80 of the transformer diagnosis and prognosis device 34 receiving (block 122) a combination of operational data 58 and non-operational data 62 related to a transformer 24 of an electrical power network 10. In response, the processing circuitry 80 of the transformer diagnosis and prognosis device 34 provides (block 124) the combination of operational data 58 and non-operational data 62 as input to a plurality of models 78 stored in the memory circuitry 76 of the transformer diagnosis and prognosis device 34. As mentioned above, this plurality of models 78 includes at least one physics-based model 88 and at least one empirical model 90.

Continuing through the process 120 illustrated in FIG. 4, the processing circuitry 80 may determine (block 126) a transformer diagnosis 92 as an output 74 of the plurality of models 78 in response to the combination of inputs 72. As mentioned above, the transformer diagnosis 92 may include a health index 98, a confidence value 100, and prescriptive action 102. The processing circuitry 80 may also determine (block 128) a transformer prognosis 94 as an output 74 of the plurality of models 78 in response to the combination of inputs 72. As mentioned above, the transformer prognosis 94 may include a failure probability 104, an expected lifetime 106, and an events probability 108. Additionally, in certain embodiments, the processing circuitry 80 may also determine (block 130) fleet ranking and capacity planning information 96 for the transformer 24 as an output 74 of the plurality of models 78, in response to the combination of inputs 72. It may be appreciated that, in certain embodiments, the actions described by block 126, 128, and 130 may be performed simultaneously or in a different order than the process 120 illustrated in FIG. 4.

Continuing through the process 120 illustrated in FIG. 4, the processing circuitry 80 may display (block 32) the transformer diagnosis 92, transformer prognosis 94, and the fleet ranking and capacity planning information 96 determined for the transformer 24. For example, the processing circuitry 80 may utilize a display that is part of the one or more output devices 86 to present a graphical user interface (GUI) that includes the transformer diagnosis 92, transformer prognosis 94, and the fleet ranking and capacity planning information 96 to the user. As mentioned above, since the outputs 74 of the transformer diagnosis and prognosis device 34 are intended to be meaningful to users that are not experts in the operation, maintenance, and/or design of the transformer 24, in certain embodiments, the GUI may use various visual or graphical elements that may aid the user in understanding the severity and/or importance of the outputs 74. By specific example, in certain embodiments, the health index 98 of a particular subsystem of the transformer 24 and/or the transformer 24 as a whole may be presented using a color-coded system, as described above. In certain embodiments, certain numerical outputs 74 (e.g., confidence value 100, failure probability 104, events probability 108) may be presented using a graphic such as a bar graph or a visual depiction of a gauge, a dial, or an indicator bar.

Additionally, in certain embodiments, the processing circuitry 80 may also store (block 134) the transformer diagnosis 92, the transformer prognosis 94, and/or the fleet ranking and capacity planning information 96, for example, in the memory circuitry 76. Further, the processing circuitry 80 may subsequently process the stored output in order to improve the accuracy of the plurality of models 78. Additionally, as maintenance and inspections are performed on the transformer 24 as part of the prescriptive action 102, this data may be incorporated into the historian/database system 18, as described above. Accordingly, the transformer diagnosis 92 and/or the transformer prognosis 94 may be validated against actual outcomes that are collected as historical data over time, and then the plurality of models 78 may subsequently be updated to provide better correlations between possible combinations of operational data 58 and non-operational data 62 and the present and future condition of the transformer 24.

The following describes an example of the transformer diagnosis and prognosis device 34 determining a transformer diagnosis 92, a transformer prognosis 94, and fleet ranking and capacity planning information 96, based on a combination of operational data 58 and non-operational data 62. In this example, the transformer diagnosis and prognosis device 34 receives operational data 58 from two online monitoring devices 26A and 26B, which are performing measurements on the main tank subsystem 50 and the bushings subsystem 52 of the transformer 24, respectively. In particular, the online monitoring device 26A is a DGA device that is performing dissolved gas analysis (DGA) on the oil of the main tank subsystem 50, and the online monitoring device 26B includes a plurality of electrical sensors performing a plurality of electrical measurements on the bushings subsystem 52 of the transformer 24. Accordingly, the transformer diagnosis and prognosis device 34 may receive this operational data 58 directly from the online monitoring devices 26A and 26B, from a data concentrator associated with the online monitoring devices 26A and 26B, or from a control and/or monitoring systems 14 associated with the online monitoring devices 26A and 26B.

Continuing with this example, the transformer diagnosis and prognosis device 34 may also receive non-operational data 62 that is associated with the transformer 24 from a historian/database system 18. For this example, the non-operational data 62 includes maintenance data 64 for the transformer 24. In particular, the maintenance data 64 includes a winding resistance test performed on the transformer 24 while the transformer is off-line for maintenance or inspection. Further, the maintenance data 64 includes one or more infrared images of the transformer 24 collected during an inspection of the transformer 24 during operation. Additionally, the non-operational data 62 may also include a network model for the electrical power network 10, a geographical location of the transformer 24, and an inventory of spare parts compatible with the transformer 24.

Continuing with the example, the DGA operational data 58 collected by the online monitoring device 26A indicates an anomaly as one or more gases demonstrate an increase in concentration. The operational data 58 collected by the online monitoring device 26B includes a bushing power factor measurement that demonstrates that the phase-B bushing power factor has spiked slightly over the last few days. The winding resistance measurement that is part of the non-operational data 62 demonstrates a slightly higher resistance for the phase-B bushing compared to phase-A or phase-C bushings. Further, the one or more infrared images collected as part of the non-operational data 62 demonstrate a bright spot at the bottom of the phase-B bushing.

Continuing with the example, when considered separately, the operational data 58 (e.g., the DGA data and the bushing power factor data) and the non-operational data 62 (e.g., the winding resistance test data and the infrared image data) do not yield a precise diagnosis or prognosis. However, since the transformer diagnosis and prognosis device 34 considers (and uses as input) the combination of all available operational data 58 and non-operational data 62, the transformer diagnosis and prognosis device 34 is capable of determining a precise transformer diagnosis 92 and transformer prognosis 94 from the plurality of models 78. For example, the transformer diagnosis and prognosis device 34 may determine a transformer diagnosis 92 indicating that the transformer 24 is experiencing high-temperature deterioration at the phase-B bushing-winding lead interface due to a loose connection. For this example, the transformer diagnosis 92 a health index 98 (e.g., a color value of yellow or a numeric value of 6 out of a possible 10) and a confidence value 100 (e.g., a numeric value of 90 of possible 100, 90%), indicating that the transformer diagnosis and prognosis device 34 is fairly confident that the transformer 24 is experiencing such issues. Further, for this example, the transformer diagnosis 92 includes prescriptive actions 102 that recommend replacing the phase-B bushing, replacing the phase-B winding lead, and filtering or replacing the transformer oil to remove contaminants.

For this example, the transformer diagnosis and prognosis device 34 also determines a transformer prognosis 94 for the transformer 24 based on the combination of operational data 58 and non-operational data 62. For example, the transformer prognosis 94 includes a failure probability 104 (e.g., a numeric value of approximately 70 of possible 100, 70%) within a particular time frame (e.g., 1 week). Additionally, the transformer prognosis 94 includes an expected lifetime 106 (e.g., approximately 5 days) if the transformer 24 continues to operate as it is currently operating. Further, the transformer prognosis 94 includes an events probability 108 (e.g., a numeric value of approximately 85 of possible 100, 85%), which is higher than the failure probability 104 for the transformer 24 since the transformer 24 is also geographical located in a hurricane risk zone during hurricane season.

For this example, the transformer diagnosis and prognosis device 34 also determines fleet ranking and capacity planning information 96 for the transformer 24 based on the combination of operational data 58 and non-operational data 62. For example, this fleet ranking and capacity planning information 96 may include a criticality index 110 (e.g., 10 out of 100, 10%) for the transformer 24 that takes into consideration the network model for the electrical power network 10. Based on the criticality index 110 of the transformer 24 and the health index 98 and/or failure probability 104 of the transformer 24, the fleet ranking and capacity planning information 96 may include recommendations for scheduling maintenance, inspection, and/or outages for the transformer 24 relative to other equipment in the electrical power network 10. Further, based on the inventory of spare parts compatible with the transformer 24, the fleet ranking and capacity planning information 96 may include recommendations for prioritizing the ordering replacement parts for the transformer 24 that are not currently in the inventory of spare parts for the transformer 24.

The technical effects of the present disclosure enable the determination of a diagnosis and a prognosis for a transformer of an electrical power network based on a combination of operational data inputs and non-operational data inputs via the disclosed transformer diagnosis and prognosis device. This combination of inputs is supplied to a number of stored models, including a physics-based model and an empirical model, and the transformer diagnosis and prognosis is provided as output from the stored models. The one or more physics-based models correlate combinations of particular operational and non-operational data values with particular physical phenomena associated with the transformer according to the physics that govern the operation of the transformer, while the empirical model correlates combinations of particular operational and non-operational data values with particular conditions of the transformer according to entrained statistical trends and expert knowledge of issues that transformers tend to experience. These stored models provide as outputs a transformer diagnosis, which may include a health index, a confidence value, and prescriptive action, as well as a transformer prognosis, which may include a failure probability, an expected lifetime, and an events probability. Accordingly, present embodiments enable an accurate determination of the current and future state of health of the transformer from combinations of operational and non-operational data, in which each piece of operational and non-operational data, when taken alone, would be insufficient to make such determinations. Further, present embodiments enable improved capacity planning and fleet ranking to improve the prioritization of inspecting and maintaining a particular transformer relative to other transformers of the electrical power network.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. A system, comprising:
a power transformer diagnosis and prognosis device (34), comprising:
communication circuitry (82) configured to receive a particular combination of operational (58) and non-operational (62) power transformer data related the power transformer (24); and
memory circuitry (76) configured to store a plurality of models (78), wherein the plurality of models (78) includes:
at least one physics-based model (88) comprising correlations between combinations of operational (58) and non-operational (62) power transformer data and potential conditions of one or more subsystems (50,52,54,56) of the power transformer (24), wherein the physics-based correlations represent physical processes that can occur in each of the one or more subsystems (50,52,54,56) of the power transformer (24), and
at least one empirical model (90) comprising statistical correlations between combinations of operational (58) and non-operational (62) power transformer data and potential conditions of each subsystem (50,52,54,56) of the power transformer (24), wherein the statistical correlations represent statistical trends and expert knowledge of conditions that tend to occur in each
subsystem (50,52,54,56) of the power transformer (24); and
processing circuitry (80) configured to:
provide the received particular combination of operational (58) and non-operational (62) power transformer data as inputs (72) to the plurality of models (78);
determine a diagnosis (92) for the power transformer (24) from outputs (74) of the plurality of models (78);
determine a prognosis (94) for the power transformer (24) from the outputs (74) of the plurality of models (78); and
display the diagnosis (92) and the prognosis (94) for the power transformer (24) on a display device.

2. The system of claim 1, wherein the processing circuitry (80) is configured to:
determine the diagnosis (92) for each of the one or more subsystems (50,52) of the power transformer (24) from the outputs (74) of the plurality of models (78);
determine the prognosis (94) for each of the one or more subsystems (50,52) of the power transformer (24) from the outputs (74) of the plurality of models (78); and
display the diagnosis (92) and the prognosis (94) for each of the one or more subsystems (50,52) of the power transformer (24) on the display device.

3. The system of claim 1 or 2, comprising the power transformer (24) that includes the one or more subsystems (50,52), wherein the one or more subsystems (50,52) comprises a main tank subsystem (50), a bushings subsystem (52), a thermal subsystem (54), and a tap change subsystem (56).

4. The system of any of claims 1 to 3, wherein the diagnosis (92) comprises a health index (98) for the power transformer (24), a confidence value (100) for the health index (98) of the power transformer (24), and prescriptive action (102) for the power transformer (24).

5. The system of any of claims 1 to 4, wherein the prognosis (94) comprises a failure probability (104) for the power transformer (24), an expected lifetime (106) for the power transformer (24), and an events probability (108) for the power transformer (24).

6. The system of any preceding claim, comprising one or more online monitoring devices (26A-D) configured to collect the operational data (58) and/or the non-operational power (62) transformer data related to the one or more subsystems of the particular power transformer (24) and configured to provide the operational data (58) to the communication circuitry (82).

7. The system of any preceding claim, wherein the operational data (58) comprises per phase voltage and current vectors, transformer loading and/or overloading, transient voltage and current events, ambient temperature, winding resistance, leakage reactance, core excitation current, core loss and excitation power factor, core ground, dissolved gas analysis (DGA), or a combination thereof, for the power transformer (24).

8. The system of any preceding claim, comprising one or more database systems configured to store non-operational data (62) pertaining to the power transformer (24), wherein the one or more database systems (16) are configured to provide the non-operational data (62) to the communication circuitry (82).

9. The system of any preceding claim, wherein the non-operational data (62) comprises winding power factor, bushing power factor, winding turns ratio, nominal ratings, current ratings, winding vector group, date of manufacture, dates and types of previous maintenance, stress events, asset book value, asset residual value, asset age, spare part inventory, failure logs, thermal imaging data, a power delivery network model, or a combination thereof, for the power transformer (24).

10. A method, comprising:
receiving operational data (58) and non-operational data (62) related to a power transformer (24) of an electrical network (10);
providing a combination of the operational and non-operational data (58,62) as inputs (72) to a plurality of models (78), wherein the plurality of models (78) includes:
at least one physics-based model (88) comprising correlations between combinations of operational (58) and non-operational (62) power transformer data and potential conditions of one or more subsystems (50,52,54,56) of the power transformer (24), wherein the physics-based correlations represent physical processes that can occur in each of the one or more subsystems (50,52,54,56) of the power transformer (24), and
at least one empirical model (90) comprising statistical correlations between combinations of operational (58) and non-operational (62) power transformer data and potential conditions of each subsystem (50,52,54,56) of the power transformer (24), wherein the statistical correlations represent statistical trends and expert knowledge of conditions that tend to occur comprises both physics-based correlations and statistical correlations between potential combinations of operational (58) and non-operational (62) data and potential conditions of the power transformer (24);
determining a diagnosis (92) and a prognosis (94) for the power transformer (24) from outputs (74) of the plurality of models (78) in response to the inputs (72); and
presenting the diagnosis (92) and prognosis (94) for the power transformer (24).

11. The method of claim 10, wherein the operational (58), the non-operational (62) data, or both, is collected by one or more online monitoring devices (26A-D) associated with the power transformer (24).

12. The method of any of claims 10 or 11, wherein the non-operational data (62) is received from a data repository storing maintenance data, asset data, or a combination thereof, related to the power transformer (24).

13. The method of any of claims 10 to 12, further comprising:
storing the diagnosis (92) and the prognosis (94) for the power transformer (24);
receiving and storing additional operational (58) and non-operational (62) data related to the power transformer (24);
comparing the diagnosis (92) and the prognosis (94) to the additional operational (58) and non-operational (62) data to identify additional statistical correlations; and
updating the plurality of models (78) based on the additional statistical correlations.

14. The method of any of claims 10 to 13, comprising:
determining a prescriptive action (102) and a fleet ranking for the power transformer (24) from the outputs (74) of the plurality of models (78) in response to the inputs (72); and
prioritizing the prescriptive action (102) for the power transformer (24) based on the fleet ranking of the power transformer (24).

15. A computer program comprising computer program code means adapted to perform the method of any of claims 10 to 14, when executed by a computer program.

## Patentansprüche

1. System, umfassend:
eine Netztransformatordiagnose- und -Prognosevorrichtung (34), umfassend:
Kommunikationskreise (82), die zum Empfangen einer bestimmten Kombination von betrieblichen (58) und nichtbetrieblichen (62) Netztransformatordaten konfiguriert sind, welche den Netztransformator (24) betreffen; und
Speicherkreise (76), die zum Speichern einer Vielzahl von Modellen (78) konfiguriert sind, wobei die Vielzahl von Modellen (78) Folgendes enthält:
zumindest ein physikalisch basiertes Modell (88), das Korrelationen zwischen Kombinationen von betrieblichen (58) und nichtbetrieblichen (62) Netztransformatordaten und potentiellen Bedingungen von einem oder mehr Teilsystemen (50, 52, 54, 56) des Netztransformators (24) umfasst, wobei die physikalisch basierten Korrelationen physikalische Prozesse darstellen, die in jedem des einen oder mehr Teilsystemen (50, 52, 54, 56) des Netztransformators (24) stattfinden, und
zumindest ein empirisches Modell (90), das statistische Korrelationen zwischen Kombinationen von betrieblichen (58) und nichtbetrieblichen (62) Netztransformatordaten und potentiellen Bedingungen von jedem Teilsystem (50, 52, 54, 56) des Netztransformators (24) umfasst, wobei die statistischen Korrelationen statistische Tendenzen und Expertenwissen von Bedingungen darstellen, die dazu neigen, in jedem Teilsystem (50, 52, 54, 56) des Netztransformators (24) stattzufinden; und
Verarbeitungskreise (80), die zu Folgendem konfiguriert sind:
Zuführen der empfangenen Kombination von betrieblichen (58) und nichtbetrieblichen (62) Netztransformatordaten als Eingaben (72) zur Vielzahl von Modellen (78);
Bestimmen einer Diagnose (92) für den Netztransformator (24) aus Ausgaben (74) der Vielzahl von Modellen (78);
Bestimmen einer Prognose (94) für den Netztransformator (24) aus Ausgaben (74) der Vielzahl von Modellen (78); und
Anzeigen der Diagnose (92) und der Prognose (94) für den Netztransformator (24) auf einer Anzeigevorrichtung.

2. System nach Anspruch 1, wobei die Verarbeitungskreise (80) zu Folgendem konfiguriert sind:
Bestimmen der Diagnose (92) für jedes des einen oder mehr Teilsysteme (50, 52) des Netztransformators (24) aus den Ausgaben (74) der Vielzahl von Modellen (78);
Bestimmen der Prognose (94) für jedes des einen oder mehr Teilsysteme (50, 52) des Netztransformators (24) aus den Ausgaben (74) der Vielzahl von Modellen (78); und
Anzeigen der Diagnose (92) und der Prognose (94) für jedes des einen oder mehr Teilsysteme (50, 52) des Netztransformators (24) auf der Anzeigevorrichtung.

3. System nach einem der Ansprüche 1 oder 2, umfassend den Netztransformator (24), der das eine oder mehr Teilsysteme (50, 52) enthält, wobei das eine oder mehr Teilsysteme (50, 52) ein Haupttankteilsystem (50), ein Buchsenteilsystem (52), ein thermisches Teilsystem (54) und ein Stufenumschaltungsteilsystem (56) umfassen.

4. System nach einem der Ansprüche 1 bis 3, wobei die Diagnose (92) einen Gesundheitsindex (98) für den Netztransformator (24), einen Vertrauenswert (100) für den Gesundheitsindex (98) des Netztransformators (24) und präskriptive Aktion (102) für den Netztransformator (24) umfasst.

5. System nach einem der Ansprüche 1 bis 4, wobei die Prognose (94) eine Ausfallwahrscheinlichkeit (104) für den Netztransformator (24), eine erwartete Nutzlebensdauer (106) für den Netztransformator (24) und eine Ereigniswahrscheinlichkeit (108) für den Netztransformator (24) umfasst.

6. System nach einem der vorstehenden Ansprüche, umfassend eine oder mehr Online-Überwachungsvorrichtungen (26A-D), die zum Sammeln der betrieblichen Daten (58) und/oder der nichtbetrieblichen (62) Netztransformatordaten, die das eine oder mehr Teilsysteme des bestimmten Netztransformators (24) betreffen, konfiguriert sind und zum Zuführen der betrieblichen Daten (58) zu den Kommunikationskreisen (82) konfiguriert sind.

7. System nach einem der vorstehenden Ansprüche, wobei die betrieblichen Daten (58) Spannungs- und Stromvektoren pro Phase, Transformatorladung und/oder - überladung, transiente Spannungs- und Stromereignisse, Umgebungstemperatur, Wicklungswiderstand, Streureaktanz, Kernerregungsstrom, Kernverlust- underregungsleistungsfaktor, Kernerde, Gas-in-öl-Analyse (DGA) oder eine Kombination davon für den Netztransformator (24) umfassen.

8. System nach einem der vorstehenden Ansprüche, umfassend ein oder mehr Datenbanksysteme, die zum Speichern von nichtbetrieblichen Daten (62), die zum Netztransformator (24) gehören, konfiguriert sind, wobei das eine oder mehr Datenbanksysteme (16) zum Zuführen der nichtbetrieblichen Daten (62) zu den Kommunikationskreisen (82) konfiguriert sind.

9. System nach einem der vorstehenden Ansprüche, wobei die nichtbetrieblichen Daten (62) Wicklungsleistungsfaktor, Buchsenleistungsfaktor, Wicklungsdrehungsverhältnis, Nennleistungen, Nennströme, Wicklungsvektorgruppe, Herstellungsdatum, Daten und Arten von vorheriger Wartung, Belastungsereignisse, Vermögenswert, Restvermögenswert, Alter, Ersatzteilinventar, Ausfallprotokolle, thermische Abbildungsdaten, ein Leistungsabgabennetzmodell oder eine Kombination davon für den Netztransformator (24) umfassen.

10. Verfahren, umfassend:
Empfangen von betrieblichen Daten (58) und nichtbetrieblichen Daten (62), die einen Netztransformator (24) in einem elektrischen Netz (10) betreffen;
Zuführen einer Kombination der betrieblichen und nichtbetrieblichen Daten (58, 62) als Eingaben (72) zu einer Vielzahl von Modellen (78), wobei die Vielzahl von Modellen (78) Folgendes enthält:
zumindest ein physikalisch basiertes Modell (88), das Korrelationen zwischen Kombinationen von betrieblichen (58) und nichtbetrieblichen (62) Netztransformatordaten und potentiellen Bedingungen von einem oder mehr Teilsystemen (50, 52, 54, 56) des Netztransformators (24) umfasst, wobei die physikalisch basierten Korrelationen physikalische Prozesse darstellen, die in jedem des einen oder mehr Teilsystemen (50, 52, 54, 56) des Netztransformators (24) stattfinden, und
zumindest ein empirisches Modell (90), das statistische Korrelationen zwischen Kombinationen von betrieblichen (58) und nichtbetrieblichen (62) Netztransformatordaten und potentiellen Bedingungen von jedem Teilsystem (50, 52, 54, 56) des Netztransformators (24) umfasst, wobei die statistischen Korrelationen statistische Tendenzen und Expertenwissen von Bedingungen darstellen, die dazu neigen, stattzufinden, umfassend sowohl physikalisch basierte Korrelationen als auch statistische Korrelationen zwischen potentiellen Kombinationen von betrieblichen (58) und nichtbetrieblichen (62) Daten und potentiellen Bedingungen des Netztransformators (24);
Bestimmen einer Diagnose (92) und einer Prognose (94) für den Netztransformator (24) aus Ausgaben (74) der Vielzahl von Modellen (78) in Reaktion auf die Eingaben (72); und
Darstellen der Diagnose (92) und Prognose (94) für den Netztransformator (24).

11. Verfahren nach Anspruch 10, wobei die betrieblichen (58), die nichtbetrieblichen (62) Daten oder beide durch eine oder mehr Online-Überwachungsvorrichtungen (26A-D) gesammelt werden, die dem Netztransformator (24) zugeordnet sind.

12. Verfahren nach einem der Ansprüche 10 oder 11, wobei die nichtbetrieblichen Daten (62) aus Datendepotspeicherwartungsdaten, Inventardaten oder einer Kombination davon, die den Netztransformator (24) betreffen, gesammelt werden.

13. Verfahren nach einem der Ansprüche 10 bis 12, weiter umfassend:
Speichern der Diagnose (92) und der Prognose (94) für den Netztransformator (24);
Empfangen und Speichern von zusätzlichen betrieblichen (58) und nichtbetrieblichen (62) Daten, die den Netztransformator (24) betreffen;
Vergleichen der Diagnose (92) und der Prognose (94) mit den zusätzlichen betrieblichen (58) und nichtbetrieblichen (62) Daten zum Identifizieren von zusätzlichen statistischen Korrelationen; und
Aktualisieren der Vielzahl von Modellen (78) auf Grundlage der zusätzlichen statistischen Korrelationen.

14. Verfahren nach einem der Ansprüche 10 bis 13, umfassend:
Bestimmen einer präskriptiven Aktion (102) und einer Flottenrangordnung für den Netztransformator (24) aus den Ausgaben (74) der Vielzahl von Modellen (78) in Reaktion auf die Eingaben (72); und
Priorisieren der präskriptiven Aktion (102) für den Netztransformator (24) auf Grundlage der Flottenrangordnung des Netztransformators (24).

15. Computerprogramm, umfassend Computerprogrammcodemittel, die zum Ausführen des Verfahrens gemäß einem der Ansprüche 10 bis 14 geeignet ist, wenn sie auf einem Computerprogramm ausgeführt werden.

## Revendications

1. Système comprenant :
un dispositif de diagnostic et de pronostic de transformateur de puissance (34), comprenant :
une circuiterie de communication (82) configurée pour recevoir une combinaison particulière de données de transformateur de puissance opérationnelles (58) et non opérationnelles (62) se rapportant au transformateur de puissance (24) ; et
une circuiterie de mémoire (76) configurée pour stocker une pluralité de modèles (78), dans lequel la pluralité de modèles (78) comprend :
au moins un modèle à base physique (88) comprenant des corrélations entre des combinaisons de données de transformateur de puissance opérationnelles (58) et non opérationnelles (62) et des conditions potentielles d'un ou plusieurs sous-systèmes (50, 52, 54, 56) du transformateur de puissance (24), dans lequel les corrélations à base physique représentent des processus physiques qui peuvent se produire dans chacun des un ou plusieurs sous-systèmes (50, 52, 54, 56) du transformateur de puissance (24) et
au moins un modèle empirique (90) comprenant des corrélations statistiques entre des combinaisons de données de transformateur de puissance opérationnelles (58) et non opérationnelles (62) et des conditions potentielles de chaque sous-système (50, 52, 54, 56) du transformateur de puissance (24), dans lequel les corrélations statistiques représentent des tendances statistiques et une expertise de conditions qui ont tendance à se produire dans chaque sous-système (50, 52, 54, 56) du transformateur de puissance (24) ; et
une circuiterie de traitement (80) configurée pour :
fournir la combinaison particulière reçue de données de transformateur de puissance opérationnelles (58) et non opérationnelles (62) comme entrées (72) dans la pluralité de modèles (78) ;
déterminer un diagnostic (92) pour le transformateur de puissance (24) à partir de sorties (74) de la pluralité de modèles (78) ;
déterminer un pronostic (94) pour le transformateur de puissance (24) à partir des sorties (74) de la pluralité de modèles (78) ; et
afficher le diagnostic (92) et le pronostic (94) pour le transformateur de puissance (24) sur un dispositif d'affichage.

2. Système selon la revendication 1, dans lequel la circuiterie de traitement (80) est configurée pour :
déterminer le diagnostic (92) pour chacun des un ou plusieurs sous-systèmes (50, 52) du transformateur de puissance (24) à partir des sorties (74) de la pluralité de modèles (78) ;
déterminer le pronostic (94) pour chacun des un ou plusieurs sous-systèmes (50, 52) du transformateur de puissance (24) à partir des sorties (74) de la pluralité de modèles (78) ; et
afficher le diagnostic (92) et le pronostic (94) pour chacun des un ou plusieurs sous-systèmes (50, 52) du transformateur de puissance (24) sur le dispositif d'affichage.

3. Système selon la revendication 1 ou 2, comprenant le transformateur de puissance (24) qui comprend les un ou plusieurs sous-systèmes (50, 52), dans lequel les un ou plusieurs sous-systèmes (50, 52) comprennent un sous-système de réservoir principal (50), un sous-système de passage (52), un sous-système thermique (54) et un sous-système de changement de prise (56).

4. Système selon l'une quelconque des revendications 1 à 3, dans lequel le diagnostic (92) comprend un indice de santé (98) pour le transformateur de puissance (24), une valeur de confiance (100) pour l'indice de santé (98) du transformateur de puissance (24) et une action prescriptive (102) pour le transformateur de puissance (24).

5. Système selon l'une quelconque des revendications 1 à 4, dans lequel le pronostic (94) comprend une probabilité de défaillance (104) pour le transformateur de puissance (24), une durée de vie attendue (106) pour le transformateur de puissance (24) et une probabilité d'événements (108) pour le transformateur de puissance (24).

6. Système selon l'une quelconque des revendications précédentes, comprenant un ou plusieurs dispositifs de surveillance en ligne (26A-D) configurés pour recueillir les données de transformateur de puissance opérationnelles (58) et/ou non opérationnelles (62) en rapport avec les un ou plusieurs sous-systèmes du transformateur de puissance particulier (24) et configurés pour fournir les données opérationnelles (58) à la circuiterie de communication (82).

7. Système selon l'une quelconque des revendications précédentes, dans lequel les données opérationnelles (58) comprennent par vecteurs de tension et de courant de phase, une charge et/ou une surcharge du transformateur, des événements de tension et de courant transitoires, une température ambiante, une résistance des enroulements, une réactance de perte, un courant d'excitation du noyau, une perte et un facteur de puissance d'excitation du noyau, une mise à la terre du noyau, une analyse de gaz dissous (DGA) ou une de leurs combinaisons pour le transformateur de puissance (24).

8. Système selon l'une quelconque des revendications précédentes, comprenant un ou plusieurs systèmes de bases de données configurés pour stocker des données non opérationnelles (62) appartenant au transformateur de puissance (24), dans lequel les un ou plusieurs systèmes de bases de données (16) sont configurés pour fournir les données non opérationnelles (62) à la circuiterie de communication (82).

9. Système selon l'une quelconque des revendications précédentes, dans lequel les données non opérationnelles (62) comprennent un facteur de puissance des enroulements, un facteur de puissance de passage, un rapport de spires d'enroulement, des débits nominaux, des débits courants, un groupe de vecteurs d'enroulement, une date de fabrication, des dates et des types d'entretien précédent, des événements de contrainte, une valeur comptable de l'actif, une valeur résiduelle de l'actif, un âge de l'actif, un inventaire de pièces de rechange, des registres de pannes, des données d'imagerie thermique, un modèle de réseau de fourniture d'énergie ou une de leurs combinaisons pour le transformateur de puissance (24).

10. Procédé comprenant :
la réception de données opérationnelles (58) et de données non opérationnelles (62) en rapport avec un transformateur de puissance (24) d'un réseau électrique (10) ;
la fourniture d'une combinaison des données opérationnelles et non opérationnelles (58, 62) comme entrées (72) dans une pluralité de modèles (78), dans lequel la pluralité de modèles (78) comprend :
au moins un modèle à base physique (88) comprenant des corrélations entre des combinaisons de données de transformateur de puissance opérationnelles (58) et non opérationnelles (62) et des conditions potentielles d'un ou plusieurs sous-systèmes (50, 52, 54, 56) du transformateur de puissance (24), dans lequel les corrélations à base physique représentent des processus physiques qui peuvent se produire dans chacun des un ou plusieurs sous-systèmes (50, 52, 54, 56) du transformateur de puissance (24) et
au moins un modèle empirique (90) comprenant des corrélations statistiques entre des combinaisons de données de transformateur de puissance opérationnelles (58) et non opérationnelles (62) et des conditions potentielles de chaque sous-système (50, 52, 54, 56) du transformateur de puissance (24), dans lequel les corrélations statistiques représentent des tendances statistiques et une expertise de conditions qui tendent à se produire comprend à la fois des corrélations à base physique et des corrélations statistiques entre des combinaisons potentielles de données opérationnelles (58) et non opérationnelles (62) et des conditions potentielles du transformateur de puissance (24) ;
la détermination d'un diagnostic (92) et d'un pronostic (94) pour le transformateur de puissance (24) à partir de sorties (74) de la pluralité de modèles (78) en réponse aux entrées (72) ; et
la présentation du diagnostic (92) et du pronostic (94) pour le transformateur de puissance (24).

11. Procédé selon la revendication 10, dans lequel les données opérationnelles (58), les données non opérationnelles (62) ou les deux sont recueillies par un ou plusieurs dispositifs de surveillance en ligne (26A-D) associés au transformateur de puissance (24).

12. Procédé selon l'une quelconque des revendications 10 ou 11, dans lequel les données non opérationnelles (62) sont reçues d'un dépôt de données stockant des données d'entretien, des données d'actifs ou une combinaison des deux en rapport avec le transformateur de puissance (24).

13. Procédé selon l'une quelconque des revendications 10 à 12, comprenant en outre :
le stockage du diagnostic (92) et du pronostic (94) pour le transformateur de puissance (24) ;
la réception et le stockage de données opérationnelles (58) et non opérationnelles (62) supplémentaires en rapport avec le transformateur de puissance (24) ;
la comparaison du diagnostic (92) et du pronostic (94) aux données opérationnelles (58) et non opérationnelles (62) supplémentaires pour identifier des corrélations statistiques supplémentaires ; et
la mise à jour de la pluralité de modèles (78) sur la base des corrélations statistiques supplémentaires.

14. Procédé selon l'une quelconque des revendications 10 à 13, comprenant :
la détermination d'une action prescriptive (102) et d'un rangement de parc pour le transformateur de puissance (24) parmi les sorties (74) de la pluralité de modèles (78) en réponse aux entrées (72) ; et
la mise en priorité de l'action prescriptive (102) pour le transformateur de puissance (24) sur la base du rangement de parc du transformateur de puissance (24).

15. Programme d'ordinateur comprenant des moyens de codage de programme d'ordinateur adaptés pour effectuer le procédé selon l'une quelconque des revendications 10 à 14, lorsqu'ils sont exécutés par un programme d'ordinateur.
